Europäisches Patentamt

European Patent Office

Office européen des brevets

(11) Publication number: **0 167 812**

A1

# EUROPEAN PATENT APPLICATION

(21) Application number: 85106861.9

(22) Date of filing: 04.06.85

(51) Int. Cl.⁴: **H 01 L 29/80**
**H 01 L 29/10**

(30) Priority: 08.06.84 US 618441

(43) Date of publication of application:
15.01.86 Bulletin 86/3

(84) Designated Contracting States:
DE FR GB NL

(71) Applicant: EATON CORPORATION
Eaton Center 111 Superior Ave.
Cleveland Ohio 44114(US)

(72) Inventor: Benjamin, James Anthony
20865 Hawthorne Ridge Court
Waukesha Wisconsin 53186(US)

(72) Inventor: Lade, Robert Walter
1009 North Jackson Street Apartment 2302
Milwaukee Wisconsin 43202(US)

(72) Inventor: Schutten, Herman Peter
8545 North Fielding Road
Bayside Wisconsin 53217(US)

(74) Representative: Wagner, Karl H.
WAGNER & GEYER Patentanwälte
Gewuerzmuehlstrasse 5 Postfach 246
D-8000 München 22(DE)

(54) **Double gate vertical JFET.**

(57) A vertical JFET (50) is provided with two gates (G1, G2) separately dedicated and referenced to respective main terminals (T1, T2) to afford bidirectional current control in AC applications without the need to commutate a single gate reference between the alternating polarity main terminals.

FIG.9

## Background And Summary

The invention relates to a junction field effect transistor (JFET) affording vertical bidirectional current flow.

Gate structure is provided for eliminating the need to commutate a single gate between alternating polarity main terminals for bidirectional current control. A double gate structure enables a first gate to be dedicated and referenced to the first main terminal, and a second gate to be dedicated and referenced to the second main terminal.

In preferred form, a first set of regions in a semiconductor body defines a first set of channels therebetween substantially coplanar along a first horizontal plane. A second set of regions defines a second set of channels therebetween substantially coplanar along a second horizontal plane vertically spaced from the first horizontal plane. The JFET has an ON state conducting bidirectional current vertically through the first and second sets of channels. The JFET has an OFF state blocking current flow through the channels due to horizontal depletion spreading pinch-off.

## Brief Description Of The Drawings

### Prior Art

FIGS. 1-4 schematically illustrate a Schockley gridistor and the sequential processing steps therefor.

FIGS. 5-8 schematically illustrate a static induction transistor (SIT) and sequential processing steps therefor.

## Present Invention

FIG. 9 schematically illustrates a vertical JFET constructed in accordance with the invention.

## Description Of Prior Art

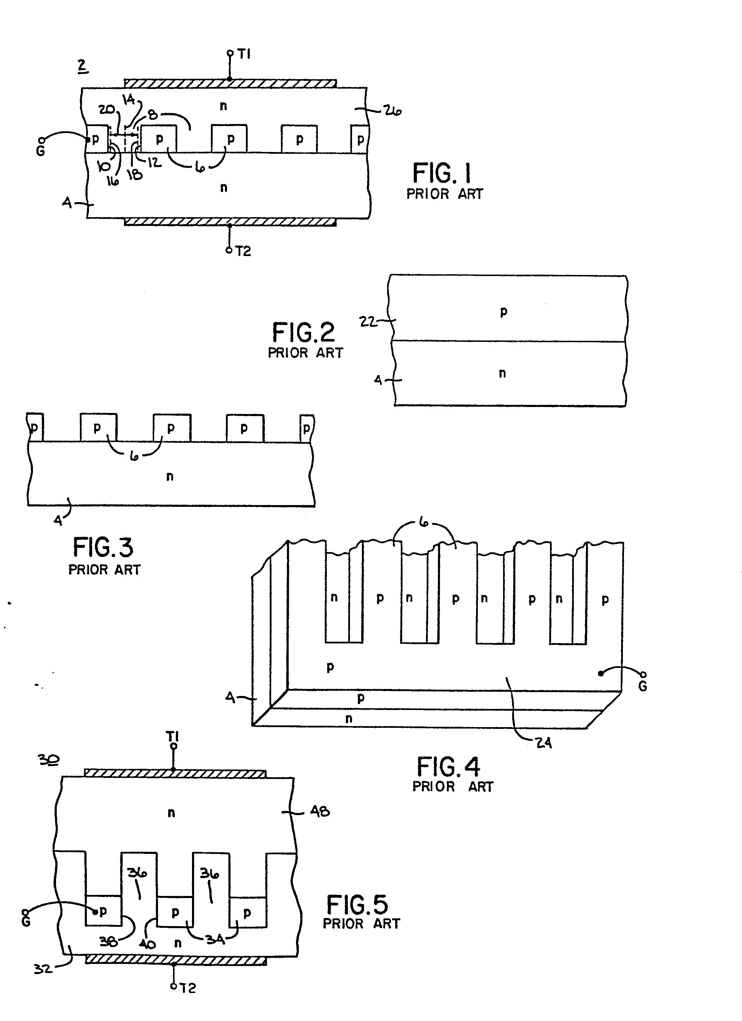

FIG. 1 shows a Schockley gridistor 2 including a semiconductor body 4 of one conductivity type having a plurality of opposite conductivity type regions such as 6 defining a plurality of channels such as 8 therebetween. Schockley gridistor 2 has an ON state conducting bidirectional current vertically through channels 8 between first and second main terminals T1 and T2. Schockley gridistor 2 has an OFF state blocking current flow through channels 8 due to depletion region spreading from the junctions such as 10 and 12 between body 4 and regions 6.

In the OFF state, the depletion regions from junctions 10 and 12 spread toward and meet each other as shown at dashed line 14 to thus pinch-off channel 8 and block conduction. In the ON state, depletion region shrinking back toward the junctions, as shown at dashed lines 16 and 18, opens a conduction path of width 20 through channel 8, enabling current flow therethrough.

Depletion region spreading from junctions 10 and 12 is controlled by the relative bias potential on gate G. Forward biasing of junctions 10 and 12 shrinks the depletion region back toward the junctions, whereas reversed biasing of junctions 10 and 12 spreads the depletion regions away from the junctions and toward each other to effect pinch-off. Schockley gridistor 2

is either normally ON or normally OFF, depending on doping concentrations, which determine the extent of depletion region spreading in the absence of biasing gate potential. If gridistor 2 is normally OFF, then gate terminal G must be positively biased to forward bias junctions 10 and 12 and thus shrink the depletion regions and open a conductive channel as at 20. If gridistor 2 is normally ON, then gate terminal G must be negatively biased to reverse bias junctions 10 and 12 and thus spread the depletion regions and close or pinch-off the conduction channel as at 14.

In AC implementations, there is alternating polarity between main terminals T1 and T2, which in turn requires that the reference for the gate voltage be commutated between the alternating polarity main terminals T1 and T2. For example, for a normally OFF gridistor 2, when T1 is positive with respect to T2, the biasing potential for gate terminal G is referenced to T2 and made positive relative thereto to turn ON gridistor 2. During the other half cycle, when T2 is positive with respect to T1, the gate voltage is referenced to T1 and made positive relative thereto. The commutation of single gate G for a normally ON gridistor 2 is comparable, with the reference for single gate terminal G being commutated between and made negative relative to alternating polarity main terminals T1 and T2, to turn gridistor 2 OFF.

The processing steps for gridistor 2 are sequentially illustrated in FIGS. 1-4. A semiconductor body 4, FIG. 2, of one conductivity type such as n type has an epitaxial layer 22 of opposite conductivity type such as p type grown thereon, followed by a masked etch to yield p regions 6, FIG. 3. FIG. 4 isometrically illustrates the front end of the structure of FIG. 3, with finger-like p regions 6 joined at front end 24 for gate connection. An n deposition is then performed to yield the upper portion 26, FIG. 1, of the semiconductor body and the channels 8 between p regions 6.

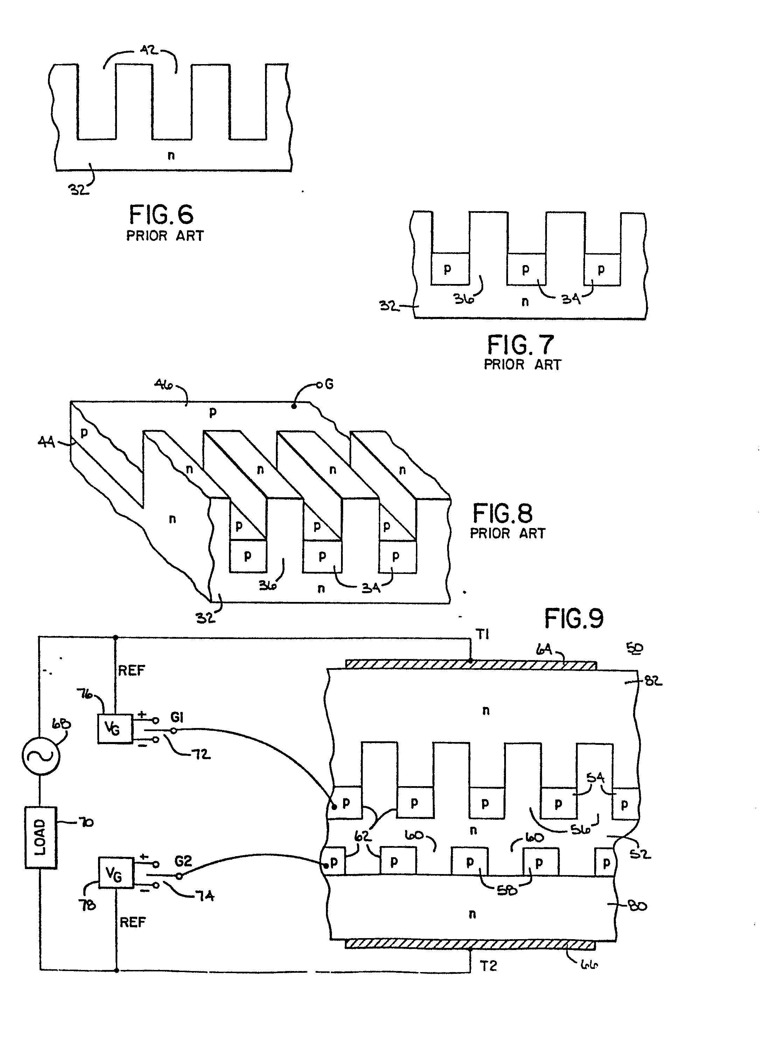

FIG. 5 schematically illustrates a static induction transistor (SIT) 30, also known as a stepped electrode transistor (SET). N type semiconductor body 32 has a plurality of p type semiconductor regions 34 defining channels such as 36 therebetween. SIT 30 has an ON state conducting bidirectional current vertically through channels 36 between main terminals T1 and T2, and has an OFF state blocking current flow through the channels due to depletion region pinch-off. Depletion region spreading is controlled by the biasing of junctions such as 38 and 40 between p regions 34 and body 32, as in gridistor 2.

The reference for gate biasing potential for terminal G, FIG. 5, is commutated between T1 and T2 in AC applications. This is necessary to provide the desired forward biasing or reverse biasing of junctions 38 and 40 as the polarity between main terminals T1 and T2 alternates.

FIGS. 5-8 illustrate the sequential processing steps for SIT 30. Beginning with a semiconductor body 32, FIG. 6, of one conductivity type such as n type, a plurality of notches 42 are anisotropically etched therein, followed by a shallow p type ion implantation in the notches and drive-in diffusion to yield p regions 34, FIG. 7. FIG. 8 isometrically illustrates the back end of the structure of FIG. 7, wherein during the etching step for notches 42, a transverse notch at 44 is formed for receiving p type material 46 during the p implant and diffusion step, for gate connection. An n deposition is then performed yielding the upper portion 48 of semiconductor body 32.

Description Of The Invention

FIG. 9 illustrates a vertical JFET 50 constructed in accordance with the invention. JFET 50 includes a semiconductor body 52 of one conductivity type, such as n type. A first set of semiconductor regions 54 in the body defines a first set of channels 56 therebetween. A second set of semiconductor regions 58 defines a second set of channels 60 therebetween. The first and second sets of regions 54 and 58 are of the other conductivity type, such as p type.

In preferred form, the first set of channels 56 is substantially coplanar along a first horizontal plane. The second set of channels 60 is substantially coplanar along a second horizontal plane vertically spaced from the first horizontal plane. P regions 54 may or may not be vertically aligned with p regions 58.

JFET 50 has an ON state conducting bidirectional current vertically through the first and second sets of channels 56 and 60. JFET 50 has an OFF state blocking current flow through the channels due to horizontal depletion region spreading and pinch-off. First gate terminal means G1 is connected to the first set of p regions 54 for controlling conduction through the first set of channels 56. Second gate terminal means G2 is connected to the second set of p regions 58 for controlling conduction through the second set of channels 60. Depletion region spreading from the junctions 62 between body 52 and the first and second sets of p regions 54 and 58 causes the pinch-off OFF state. Depletion region shrinking towards junctions 62 enables the ON state.

First main terminal means T1 is connected to the top of semiconductor body 52 by metalization 64, such as deposited aluminum. Second main terminal means T2 is connected to the bottom of semiconductor body 52 by metalization 66. The first gate terminal G1 is referenced to the first main terminal T1, and the second gate terminal G2 is referenced to the second main terminal T2. The gate reference for JFET 50 thus does not have to be commutated between main terminals T1 and T2 for bidirectional current control.

In the preferred implementation, JFET 50 is normally OFF. The depletion regions from the first and second sets of p regions 54 and 58 normally extend toward and meet each other in channels 56 and 60 in the absence of bias on gate terminals G1 and G2, such that the channels are normally pinched OFF. JFET 50 is turned ON by biasing first and second gate terminals G1 and G2 to shrink the depletion regions back toward junctions 62 and open the conductive channels therebetween such that current can flow between main terminals T1 and T2. The main terminals are connected in an AC load line including AC power source 68 and load 70. With switches 72 and 74 in their upward position, gate terminals G1 and G2 are biased positively by respective gating voltage sources 76 and 78 relative to respectively referenced main terminals T1 and T2.

Alternatively, JFET 50 may be normally ON, with the depletion regions from first and second sets of p regions 54 and 58 normally extending only partially towards each other to leave open the conductive channels therebetween such that current can flow between main terminals T1 and T2. JFET 50 is turned OFF by biasing first and second gates G1 and G2 to spread the depletion regions and pinch-off channels 56 and 60. With switches 72 and 74 in their downward position, junctions 62 are reverse biased by the negative gate potential applied respectively at Gl and G2 relative to respectively referenced main terminals Tl and T2.

JFET 50 is preferably formed from a combination of the known processing steps for Schockley gridistor 2, FIG. 1, and SIT 30, FIG. 5. The initial processing steps are those of FIGS. 1-4, with upper and lower body portions 26 and 4 of FIG. 1 corresponding to body portions 52 and 80 of FIG. 9. The processing steps of FIGS. 5-8 are then performed, using body portion 52 of FIG. 9 as the starting semiconductor body portion 32 of FIGS. 5-8. Upper body portion 82 of FIG. 9 corresponds to upper body portion 48 of FIG. 5. This fabrication method for the structure of FIG. 9 is preferred because it utilizes known processing steps. The resulting structure provides in combination a Schockley gridistor vertically integrated with a static induction transistor to provide a double gate JFET eliminating the need to commutate a single gate reference between alternating polarity main terminals for bidirectional current control.

It is recognized that various modifications are possible within the scope of the appended claims.

## CLAIMS

1.  A vertical JFET comprising:

a body of semiconductor material;

a first set of semiconductor regions in said body defining a first set of channels therebetween;

a second set of semiconductor regions in said body defining a second set of channels therebetween;

said JFET having an ON state conducting bidirectional current vertically through said first and second sets of channels;

said JFET having an OFF state blocking current flow through said channels due to horizontal depletion pinch-off.

2.  The invention according to claim 1 comprising:

first gate terminal means connected to said first set of regions for controlling conduction through said first set of channels; and

second gate terminal means connected to said second set of regions for controlling conduction through said second set of channels.

3.  The invention according to claim 2 wherein:

said first set of channels is substantially coplanar along a first horizontal plane; and

said second set of channels is substantially coplanar along a second horizontal plane vertically spaced from said first horizontal plane.

4.  The invention according to claim 3 wherein:

said semiconductor body is of one conductivity type;

said first and second sets of regions are of the other conductivity type;

depletion region spreading from the junctions between said body and said first and second sets of regions causes said pinch-off OFF state; and

depletion region shrinking towards said junctions enables said ON state.

5. The invention according to claim 2 comprising:

first main terminal means connected to the top of said semiconductor body;

second main terminal means connected to the bottom of said semiconductor body;

and wherein:

said first gate terminal means is referenced to said first main terminal means;

said second gate terminal means is referenced to said second main terminal means;

such that the gate reference for said JFET does not have to be commutated between said first and second main terminal means for bidirectional current control.

6. A vertical JFET comprising:

a body of semiconductor material of one conductivity type;

a first set of semiconductor regions of the other conductivity type in said body defining a first set of channels therebetween substantially coplanar along a first horizontal plane;

a second set of semiconductor regions of said other conductivity type in said body defining a second set of channels therebetween substantially coplanar along a second horizontal plane vertically spaced from said first horizontal plane;

first main terminal means connected to the top of said semiconductor body;

second main terminal means connected to the bottom of said semiconductor body;

said JFET having an ON state conducting bidirectional current between said first and second main terminal means vertically through said first and second sets of channels, horizontal depletion region shrinking toward the junctions between said body and said first and second sets of regions opening said channels and enabling said ON state;

said JFET having an OFF state blocking current flow through said channels due to horizontal depletion region spreading from said junctions pinching OFF said channels;

first gate terminal means connected to said first set of regions for controlling conduction through said first set of channels, and referenced to said first main terminal means;

second gate terminal means connected to said second set of regions for controlling conduction through said second set of channels, and referenced to said second main terminal means;

such that the gate reference for said JFET does not have to be commutated between said first and second main terminal means for bidirectional current control.

7. A vertical JFET comprising in combination a Schockley gridistor vertically integrated with a static induction transistor to provide a double gate JFET eliminating the need to commutate a single gate reference between alternating polarity main terminals for bidirectional current control.

1/2

0167812

FIG. 1
PRIOR ART

FIG. 2
PRIOR ART

FIG. 3
PRIOR ART

FIG. 4
PRIOR ART

FIG. 5
PRIOR ART

2/2

0167812

FIG.6
PRIOR ART

FIG. 7
PRIOR ART

FIG.8
PRIOR ART

FIG.9

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | FR-A-1 317 256 (TESZNER) <br> * Figure 11; page 3, lines 12-23; figure 14; page 4, lines 10-45; page 5, lines 10-19 * | 1-7 | H 01 L 29/80 <br> H 01 L 29/10 |
| | --- | | |
| X | US-A-4 160 259 (NISHIZAWA) <br> * Figure 9J; page 7, lines 30-53; claim 1 * | 1-7 | |
| | --- | | |
| A | IEEE TRANSACTIONS ON ELECTRON DEVICES, vol. ED-25, no, 3, March 1978, pages 314-322, IEEE, New York, US; J. NISHIZAWA et al.: "High-frequen ower static induction transistor" | | |
| | --- | | |
| A | ANNALES DES TELECOMMUNICATIONS, vol. 26, nos. 7/8, July/August 1971, pages 303-314, C.N.E.T., Issy les Moulineaux, FR; S. TESZNER: "Sur les limites en fréquence et en puissance des triodes à effet de champ" | | TECHNICAL FIELDS SEARCHED (Int Cl 4) <br><br> H 01 L |
| | --- | | |
| A | IEEE ELECTRON DEVICE LETTERS, vol. EDL-1, no. 12, December 1980, pages 250-252, IEEE, New York, US; B.J. BALIGA: "A novel buried grid device fabrication technology" | | |
| | ---     -/- | | |

The present search report has been drawn up for all claims

| Place of search <br> THE HAGUE | Date of completion of the search <br> 29-08-1985 | Examiner <br> GELEBART J.F.M. |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | US-A-3 354 362 (HUGHES AIRCRAFT CO.)<br>* Figure 2; page 6, lines 26-53; page 8, lines 6-17 * | 1-7 | |

-----

| | | | TECHNICAL FIELDS SEARCHED (Int. Cl.4) |
|---|---|---|---|

The present search report has been drawn up for all claims

| Place of search THE HAGUE | Date of completion of the search 29-08-1985 | Examiner GELEBART J.F.M. |
|---|---|---|